Europäisches Patentamt

**European Patent Office**

**Office européen des brevets**

(11) Publication number: **0 183 046**
**A2**

# (12) EUROPEAN PATENT APPLICATION

(21) Application number: **85113372.8**

(22) Date of filing: **22.10.85**

(51) Int. Cl.⁴: **G 11 B 7/125**
**H 01 S 3/10**

(30) Priority: **30.11.84 US 677117**

(43) Date of publication of application:
**04.06.86 Bulletin 86/23**

(84) Designated Contracting States:
**DE FR GB**

(71) Applicant: **International Business Machines Corporation
Old Orchard Road
Armonk, N.Y. 10504(US)**

(72) Inventor: **Gonnella, Norman T.
6423, 16th Avenue, S.W.
Rochester Minnesota 55901(US)**

(72) Inventor: **Luecke, Francis S.
Route 1 Box 192
Byron Minnesota 55920(US)**

(72) Inventor: **Soderstrom, Ronald L.
3832 16th Avenue S.W.
Rochester Minnesota 55901(US)**

(74) Representative: **Vekemans, André
COMPAGNIE IBM FRANCE Département de Propriété
Industrielle
F-06610 La Gaude(FR)**

(54) Process for reducing feedback in a semiconductor laser used in an optical data storage system.

(57) The sensitivity to light returned near to the exit aperture (17) of a semiconductor laser is reduced by depositing onto the output face of said laser a layer (17) of opaque material. When the laser is first powered up, its output ablates the opaque material from the light exit aperture.

FIG. 3

EP 0 183 046 A2

PROCESS FOR REDUCING FEEDBACK IN A SEMICONDUCTOR 0183046
LASER USED IN AN OPTICAL DATA STORAGE SYSTEM

FIELD OF THE INVENTION

This invention relates to semiconductor lasers and more particularly to a process for reducing feedback in a semiconductor laser used in an optical data storage system.

DESCRIPTION OF THE PRIOR ART

Optical data storage disks are widely used in video disk and digital audio disk (DAD) systems.

In such systems a high energy focused laser beam records the data as "data pits or holes" along an information track of an optical data storage disk. To read the recorded data, a low energy focused laser beam scans the recorded track and light reflected from the disk is sensed by a detector. Such systems are more completely described in the article: "Optical Data Storage Technology Status and Prospects" by Alan E. Bell, Computer Design, January 1983, pages 133-146.

Until recently high power gas lasers have been used to record the data but the development of optical recording media with increased recording sensitivity has allowed optical recording of data with semiconductor lasers.

One of the requirements of such systems is a constant output power of the recording laser. Semiconductor lasers are susceptible to output power fluctuations caused by light reflected back from the surface of the disk to the output facet of the laser. This reflected light re-enters the laser and distorts the lasing action within the laser. Reflected light re-entering the laser results in noise generation and an inaccurate signal from the photosensitive diode commonly mounted on the rear face of the laser for the purpose of

RO 9 84 005

monitoring laser power output. Either result can seriously interfere with optical recording.

A conventional technique for preventing the light reflected back from the disk from re-entering the laser is to use a quarter wave plate and polarizing beam splitter. The best economical quarter wave plate systems provide a feedback reduction of only $10^{-2}$ to $10^{-3}$. As lasers used in optical data storage systems are sensitive to feedback as small as $10^{-4}$ or even less, this technique is not of itself sufficient and must be enhanced by the use of more expensive quarter wave plates or other supplemental means.

These other means for reducing feedback, such as Faraday isolators, longer optical path length or high frequency modulation have been considered but they are too big or heavy, too expensive, or create other problems such as introducing other noise sources.

## SUMMARY OF THE INVENTION

The principal object of the invention is to provide a laser for use in an optical data storage system in which the light reflected back from the optical disk to an area adjacent the light exit aperture of the laser is prevented from entering the laser by modification of the laser itself, resulting in further reduction of feedback as compared with conventional methods. Another object of the invention is to provide an optical data storage system in which the sensitivity of the laser to feedback near its light exit aperture is reduced without the use of an additional component. This allows the technique to be easily added to existing systems to provide additional feedback reduction.

These objects are accomplished by depositing an opaque material onto the output facet of the laser. When the laser is powered on the first time, its output ablates the opaque material from the light exit aperture, leaving a mask which covers the remainder of the front facet of the laser.

## BRIEF DESCRIPTION OF THE DRAWINGS

FIG. 1 is an overall block diagram of an optical data storage system.

FIG. 2 is an isometric view of the laser of FIG. 1 modified according to the invention.

FIG. 3 is an enlarged isometric view of the light exit aperture of the laser of FIG. 2.

## DETAILED DESCRIPTION OF THE INVENTION

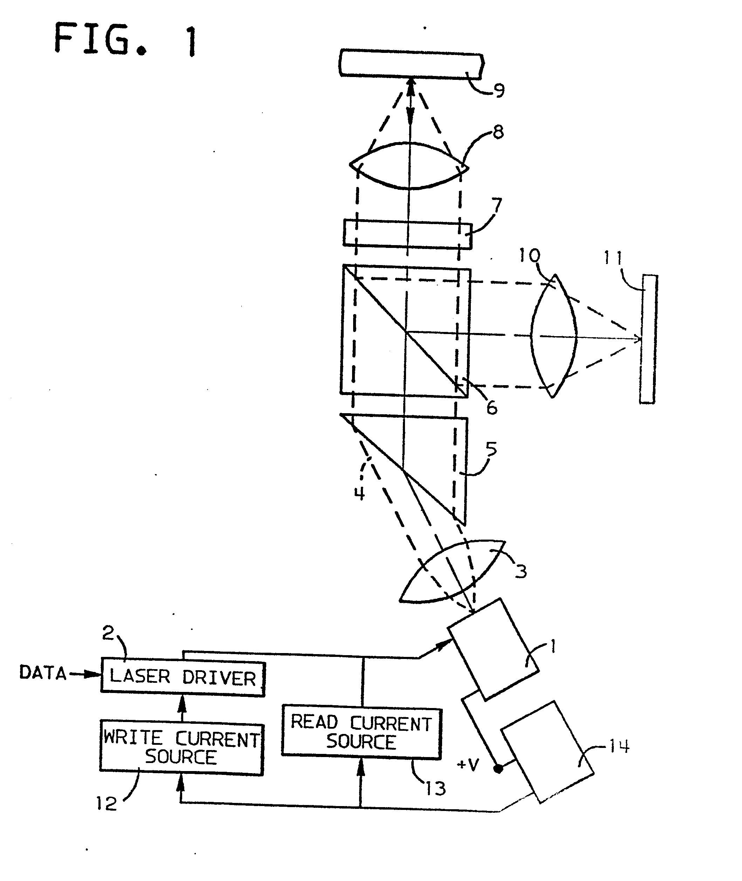

Referring first to FIG. 1, there is shown a general block diagram of an optical data storage system. A laser 1, for example, a semiconductor laser typically emitting a coherent beam of light at about 800 nm, which can be switched between a high and a low energy state, is driven by a laser driver 2. To record data, the data to be recorded is encoded using, for example, a conventional code of the type employed for magnetic recording, such as a run length limited (RLL) code. The encoded data is applied to laser driver 2 to modulate a high energy laser beam emitted by laser 1 according to the encoded data pattern. The linearly polarized laser beam generated by laser 1 is collimated by a collimating lens 3. The collimated beam 4 is projected on a prism 5 at an appropriate angle to change its cross section from elliptical to circular. The circular collimated beam enters a polarizing beam splitter 6. The polarized beam passes through a quarter wave plate 7, which circularly polarizes the beam and passes it to an objective lens 8 which focuses it onto an optical disk 9 where it forms optically detectable changes such as pits or holes, in a selected track.

To read back recorded data, laser 1 emits a low energy linearly polarized laser beam which passes through collimating lens 3, prism 5 and enters polarizing beam splitter 6. The polarized beam passes through quarter wave plate 7, which circularly polarizes the beam and passes it to objective lens 8 which focuses it onto optical disk 9. The beam reflected back from disk 9 is collected by objective lens 8 and passes through quarter wave plate 7 again. The beam is now converted back to a linearly polarized beam, but with a 90° rotation of the polarization with respect to the polarization of the incident beam, which causes it to be deflected by 90° when passing through polarizing beam splitter 6 and continues on through a lens 10 to a photodetector 11.

Laser 1 is driven by a write current source 12 and by read current source 13 which provide a DC current at a level appropriate for read and write power requirements. Laser 1 is also connected to laser write driver 2 which provides the additional current pulses necessary to write the encoded optical data.

The feedback control of read or write current function is accomplished with a monitor photodiode 14 usually located at the rear facet of the write laser. Photodiode 14 provides an output proportional to laser 1 output causing a corresponding reverse change in write and read current sources 12 and 13.

Semiconductor lasers (e.g. laser 1) exhibit output power fluctuations caused by light reflected back from the surface of disk 9 to, or near their light exit aperture. This results in noise generation and laser monitor photodiode 14 inaccuracy.

Quarter wave plate 7 and polarizing beam splitter 6 prevent most of the light reflected back from disk 9 from re-entering laser 1. Since commercial grade quarter wave plate systems provide a feedback reduction of $10^{-2}$ to $10^{-3}$ and lasers used in optical data storage systems are sensitive to feedback as small as $10^{-4}$, this is not of itself sufficient to provide constant output power of the laser.

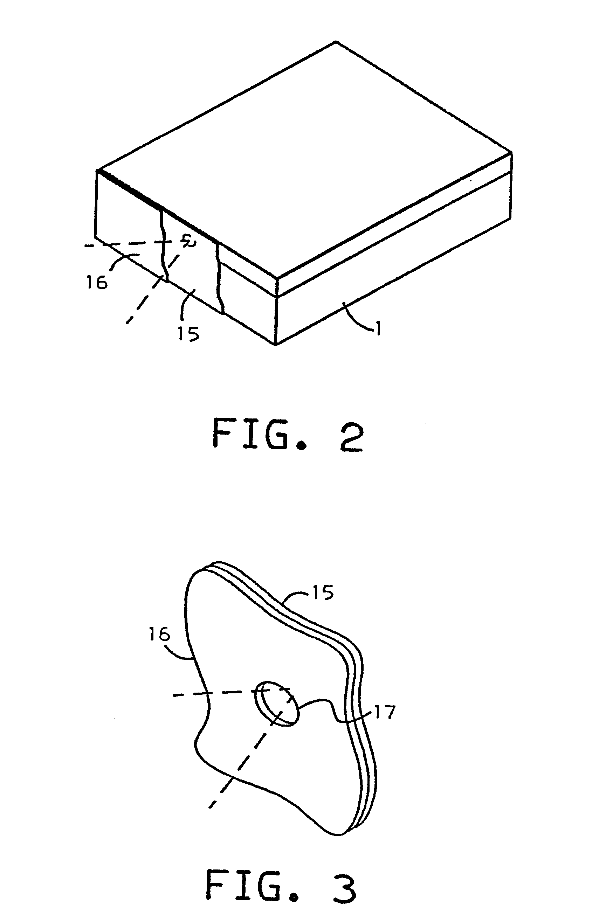

FIG. 2 is a representation of laser 1 of FIG. 1, typically a GaAlAs semiconductor laser, modified according to the invention.

In a first step, a layer 15 of a protective and insulating material, which is light transmissive, is applied onto the output facet of laser 1. Suitable protective and insulating materials include glasses commonly used with semiconductors, such as $Al_2O_3$, $SiO_2$ and SiO. Layer 15 protects the output facet of laser 1 from degradation by the subsequent processes and by the environmental conditions encountered. Layer 15 also keeps the following layer from electrically shorting the various layers of laser 1 together. By choosing the thickness of layer 15 equal to a quarter wavelength ($\lambda/4$), the reflection of the front facet of laser 1 is reduced and also the efficiency of the light output from the lasing cavity is enhanced.

In a further step, a layer 16 of an opaque ablatable material is applied onto insulating layer 15. Suitable ablatable materials include Te, Au, Al, Ti and Te based alloys. The material is selected for maximum opacity and compatibility with the process of application and hole forming and with the other materials in the laser. The thickness is chosen to provide sufficient masking opacity and yet remain applicable and removable with an acceptable amount of time and energy. A typical thickness is about 1500 A.

The application of layers 15 and 16 can be made by means of a conventional vacuum deposition technique such as described in: "Thin Film Processes" edited by J. L. Vossen and W. Kern, Academic Press, 1978.

In the next step, the laser is first powered up to its normal maximum power. The opaque material of layer 16 is evaporated

0183046

or melted away from the output beam cross-sectional area and forms an output window 17, as shown in FIG. 3. Since output window 17 has about the same area as the spot typically used at the optical disk surface for optical data recording, the energy density at window 17 will be sufficient to remove the opaque material.

The process according to the invention provides a very simple solution to the problem of the light reflected back near the light exit aperture of the laser with a minimum of process step.

While the invention has been particularly shown and described with respect to a preferred embodiment thereof, it will be understood by those skilled in the art that various changes in form and details may be made therein without departing from the spirit and scope of the invention.

RO 9 84 005

**0183046**

CLAIMS

1. A process for fabricating a semiconductor laser (1), characterized in that it comprises the steps of

   depositing a layer (16) of opaque material on said laser output facet, and

   powering on said laser, whereby said opaque material is ablated from the light exit aperture of said laser.

2. A process according to claim 2 characterized in that it includes the further step of depositing a layer of protective and insulating material on said laser output facet before depositing said layer of opaque material.

3. A process according to claim 2 characterized in that said opaque material is selected in a group including Te, Au, Al, Ti and Te alloys.

4. A process according to claim 2 characterized in that said opaque material is Te.

5. A process according to any of claims 1 - 4 characterized in that the thickness of said layer of opaque material is about 1500 $\overset{o}{A}$.

6. A process according to any of claims 2 - 5 characterized in that said protective and insulating material is selected in a group including $Al_2O_3$, $SiO_2$ and $SiO$.

0183046

7.  A process according to anyone of claims 2 - 6 characterized in that said layer of opaque material and said layer of protective and insulating material are deposited by a vacuum deposition technique.

8.  A semiconductor laser (1) having an output facet, through which the laser beam exits at a light exit aperture, and apparatus for reducing the laser's susceptibility to noise caused by light entering into the laser through the output facet, characterized in that it comprises:

    a layer (16) of opaque material on the output facet of the laser, and

    a hole ablated in said layer of opaque material only at the light exit aperture (17) of said laser.

9.  A semiconductor laser according to claim 8 characterized in that it further comprises a layer of protective and insulating material between said output facet and said layer of opaque material.

10. A semiconductor laser according to claim 7 characterized in that said opaque material is selected in a group including Te, Au, Al, Ti and Te alloys.

11. A semiconductor laser according to claim 10 characterized in that said layer of opaque material is about 1500 A.

12. A semiconductor laser according to claim 11 characterized in that said protective and insulating material is selected in a group including $Al_2O_3$, $SiO_2$ and SiO.

13. An optical data storage system comprising;

a semiconductor laser (11) emitting a polarized coherent beam of light through a light (4) exit aperture (17),

an information storage medium (9),

light detection means (11),

an optical system (5, 6, 7, 8, 10) for focusing said beam of light onto said storage medium and for focusing the portion of said beam affected by said storage medium onto said light detection means, characterized in that said semiconductor laser has a layer (16) of opaque material deposited on its output facet and a hole ablated in said layer of opaque material at the light exit aperture of said laser.

14. An optical data storage system according to claim 13 characterized in that it further comprises

a power monitor diode providing an output signal proportional to the output power of said semiconductor laser to control the input power of said semiconductor laser at a desired level.

15. An optical data storage system according to claim 14 characterized in that said semiconductor laser further comprises a layer (15) of protective and insulating material between said output facet and said opaque material.

# FIG. 1

16
15
1

FIG. 2

15
16
17

FIG. 3